# EUROPEAN PATENT SPECIFICATION

(11) **EP 1 431 405 B1**
(45) Date of publication and mention of the grant of the patent: **03.01.2007**
(21) Application number: 03027438.5
(22) Date of filing: 29.11.2003
(51) Int. Cl.: C22C 19/05, C30B 11/00, C30B 29/52, C23C 30/00

(54) **Coated article comprising a nickel base superalloy**
Beschichtete Artikel aus Superlegierung auf Nickel Basis
Article revêtu comprenant un alliage à base de nickel

(30) Priority: 16.12.2002 US 433891 P
(43) Date of publication of application: 23.06.2004
(73) Proprietor: Howmet Research Corporation, Whitehall, Michigan 49461 (US)
(72) Inventor: Murphy, Kenneth S., Norton Shores Michigan 49441 (US)
(74) Representative: Regelmann, Thomas

(56) References cited:
- EP-A- 0 676 489
- US-A- 4 643 782
- M.MARCHIONNI ET AL: ""HIGH TEMPERATURE MECHANICAL PROPERTIES OF CSMX4+YTTRIUM SINGLE CRYSTAL NICKEL-BASE SUPERALLOY" , PROC. CONF SUPERALLOYS 1992, PENNSYLVANIA, US" 1992 , TMS , US XP008029640 * page 775 - page 784; table 1 *
- M.MARCHIONNI ET AL: "EVALUATION OF HIGH TEMPERATURE BEHAVIOUR OF CMSX4 + YTTRIUM SINGLE-CRYSTAL NICKEL-BASE SUPERALLOY" JOURNAL OF MATERIALS ENGINEERING AND PERFORMANCE, vol. S, no. 4, August 1993 (1993-08), pages 497-503, XP008029645
- DATABASE CA [Online] CHEMICAL ABSTRACTS SERVICE, COLUMBUS, OHIO, US; GOLDSCHMIDT, D. ET AL: "Advanced single-crystal turbine blades" retrieved from STN Database accession no. 119:276681 CA XP002276547 & VORTR. POSTER - SYMP. MATERIALFORSCH. 1991, 2ND (1991), VOLUME 3, 2710-11 EDITOR(S): VIERKORN-RUDOLPH, B.;LILLACK, D.; CLAR, H.-J. PUBLISHER: FORSCHUNGSZENTRUM, JUELICH, GERMANY. , 1991,
- G.W.MEETHAM: "DEVELOPMENT OF GAS TURBINE MATERIALS" 1981 , APPLIED SCIENCE PUBL , LONDON, GB XP002276546 * page 274 - page 275 *

## Description

### FIELD OF THE INVENTION

The present invention relates to a coated article comprising a nickel base superalloy having improved oxidation resistance and used as a substrate to receive a bondcoat and thermal barrier coating on the bondcoat to improve adherence of the thermal barrier coating.

### BACKGROUND OF THE INVENTION

EP 0 676 489 A1 discloses a nickel-base alloy for casting single crystal turbine engine plates, vanes and combustor components for use at operating temperatures up to 1150°C without incipient melting porosity, the alloy consisting essentially of the following elements in the castings, in the following proportions expressed as percentages of weight except where otherwise noted as ppm by weight: Co 9.3-10.0, Cr 6.4-6.6, Mo 0.5-0.7, W 6.2-6.6, Ta 6.3-6.7, Al 5.45-5.75, Ti 0.8-1.2, Hf 0.07-0.12, Re 2.8-3.2, S 2 ppm max. at least one of Y, La and Ce in an amount such that the combined number of atoms of yttrium plus lanthanum plus cerium would equal the number of atoms of yttrium in the amount of 5-15 ppm if yttrium alone had been included in the alloy Ni Balance.

XP-002276546, G.W. Meetham "Development of Gas Turbine Materials", 1981, page 274, 275 describes thermal barriers used for combustors.

Superalloys are widely used as castings in the gas turbine engine industry for critical components, such as turbine blades and vanes, subjected to high temperatures and stress levels. Such critical components oftentimes are cast using well known directional solidification (DS) techniques that provide a single crystal or columnar grain microstructure to optimize properties in a particular direction.

Directional solidification casting techniques are well known wherein a nickel base superalloy remelt ingot is vacuum induction remelted in a crucible in a casting furnace and poured into a ceramic investment cluster mold disposed in the furnace having a plurality of mold cavities. During directional solidification, the superalloy melt is subjected to unidirectional heat removal in the mold cavities to produce a columnar grain structure or single crystal in the event a crystal selector or seed crystal is incorporated in the mold cavities. Unidirectional heat removal can be effected by the well known mold withdrawal technique wherein the melt-filled cluster mold on a chill plate is withdrawn from the casting furnace at a controlled rate. Alternately, a power down technique can be employed wherein induction coils disposed about the melt-filled cluster mold on the chill plate are de-energized in controlled sequence. Regardless of the DS casting technique employed, generally unidirectional heat removal is established in the melt in the mold cavities.

Such melting and DS casting processes typically have produced DS nickel base superalloy castings, such as high volume production turbine blade castings, having bulk sulfur impurity concentrations in the range of 2 to 10 parts per million (ppm) by weight. Such sulfur impurity levels have been thought to have an adverse effect on high temperature oxidation resistance of nickel base superalloys in service, especially as engine operating temperatures have increased. US Patent 5 922 148 describes nickel base superalloys having ultra low sulfur concentration to improve oxidation resistance of the superalloy.

Nickel base superalloy castings, such as gas turbine engine blades, are oftentimes coated with a thermal barrier coating system that includes a bondcoat on which a ceramic thermal barrier coating is deposited to protect the superalloy from high temperature oxidation. Thermal barrier coatings can fail in service in a gas turbine engine as a result of spallation of the ceramic thermal barrier coating off of the bondcoated substrate. The oxidation resistance of the superalloy substrate and of the bondcoat are factors that determine the service life of the ceramic thermal barrier coating system. For example, it is desirable to use a nickel base superalloy having superior oxidation resistance for retaining engine performance after the turbine blade tip has experienced a rub with a tip seal, since the rub may remove some or all blade tip coating, exposing the nickel base superalloy substrate to the hot gas turbine environment.

### SUMMARY OF THE INVENTION

The present invention provides a coated article according to claim 1.

A nickel base superalloy pursuant to the invention possesses improved high temperature oxidation resistance to help retain turbine blade tip dimensions when the tip coating is removed by rubbing against the tip seal, thereby retaining engine performance for a longer time. A nickel base superalloy substrate pursuant to the invention is coated with an outwardly grown diffusion aluminide bondcoat followed by deposition of a ceramic thermal barrier coating (TBC) on the bondcoat. Spallation of the TBC is significantly prolonged when the bondcoat comprises an outwardly grown, single phase diffusion aluminide bondcoat and the substrate comprises a superalloy pursuant to the invention.

Other advantages, features and embodiments of the present invention will become apparent from the following description taken with the following drawings.

### DESCRIPTION OF THE DRAWINGS

Figure 1 is a graph of weight change versus number of cycles in a cyclic oxidation test for specimens listed in the figure.
Figure 2 is a graph of weight change versus number of cycles of a cyclic oxidation test for specimens listed in the figure having an outwardly grown, single phase diffusion aluminide MDC-150L bondcoat on some specimens and an inwardly grown, multi-phase diffusion aluminide LDC-2E bondcoat on other specimens.
Figure 3 is a bar graph showing TBC adherence in a cyclic oxidation test for substrates having the outwardly grown aluminide diffusion MDC-150L bondcoat on some specimens and the inwardly grown aluminide diffusion LDC-2E bondcoat on other specimens.
Figure 4 is a bar graph showing TBC adherence in a cyclic oxidation test for substrates having the outwardly grown diffusion aluminide MDC-150L bondcoat.
Figure 5 is a bar graph showing TBC adherence in a cyclic oxidation test in progress for substrates having the outwardly grown diffusion aluminide MDC-150L bondcoat.

### DESCRIPTION OF THE INVENTION

The present invention provides a nickel base superalloy consisting of, in weight %, 3% to 12% Cr, up to 15% Co, up to 3% Mo, 3% to 10% W, up to 6% Re, 5% to 7% Al, up to 2% Ti, up to 1% Fe, up to 2% Nb, 3% 12% Ta, up to 0.07% C, 0.030% to 0.80% Hf, up to 0.10% Zr, up to 0.02% B, 0.0005% to 0.050% of a rare earth element selected from the group consisting of Y and Lanthanide series elements having atomic numbers 58 to 71 (preferably Ce, La and/or Er), and balance Ni and incidental impurities with a S concentration preferably of 2 ppm by weight or less.

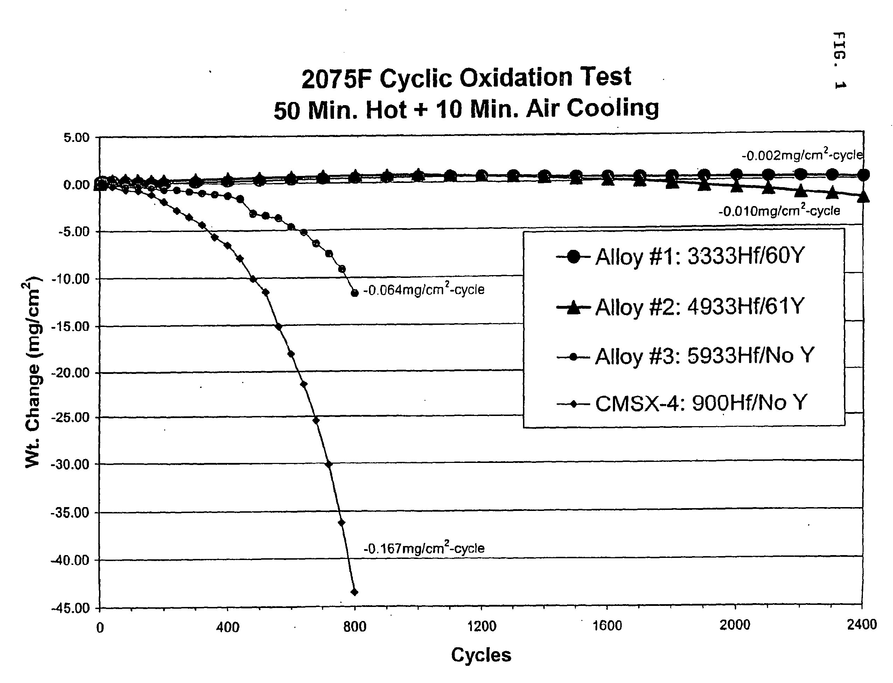

Figure 1 shows the weight change versus number of cycles in a cyclic oxidation test (Lindberg test) conducted in air at 2075 degrees F where each cycle comprised placing the specimens in a vertically oriented tube furnace for 50 minutes and then removing the specimens from the furnace to cool in air for 10 minutes. A specimen was considered failed in the cyclic oxidation testing when the specimen lost 5 mg/cm² in weight. A comparison of weight loss rates is made to assess the effectiveness of alloy chemistry changes on oxidation resistance. In most cases, a slower weight loss rate is better than a higher weight loss rate.

A comparison baseline nickel base superalloy known as CMSX-4 superalloy described in US Patent 4 643 782 was tested to provide baseline specimens for comparison. The CMSX-4 test alloy comprised a nominal composition as shown in Table 1 below. Another comparison nickel base superalloy shown as alloy 3 having an Hf addition but no intentional Y addition also was tested for comparison. The nominal composition of test alloy 3 is shown in Table 1 below.

Nickel base superalloy test alloys 1 and 2 pursuant to the invention were also cyclic oxidation tested in the same manner. The nominal compositions of the test alloys 1 and 2 are shown in Table 1 below.

**Table 1: Nominal Chemistries**

| | **Y (ppm)** | **Hf (ppm)** | **S (ppm)** | **Ti (% Wt.)** | **Al (% Wt.)** | **Cr (% Wt.)** | **Co (% Wt.)** | **Mo (% Wt.)** | **Ni (% Wt.)** | **Re (% Wt.)** | **Ta (% Wt.)** | **W (% Wt.)** |
|---|---|---|---|---|---|---|---|---|---|---|---|---|
| CMSX-4 | 1.7 | 900 | 2.0 | 1.0 | 5.6 | 6.3 | 9.5 | 0.6 | Bal. | 2.9 | 6.4 | 6.5 |
| Specimen 1 | 60.3 | 3333 | 1.3 | 1.0 | 5.7 | 6.3 | 9.5 | 0.6 | Bal. | 2.9 | 6.4 | 6.4 |
| Specimen 2 | 61.3 | 4933 | 1.0 | 1.0 | 5.5 | 6.3 | 9.6 | 0.6 | Bal. | 3.0 | 6.4 | 6.5 |
| Specimen 3 | 1.0 | 5933 | 2.0 | 1.0 | 5.8 | 6.3 | 9.6 | 0.5 | Bal. | 2.9 | 6.4 | 6.4 |
| | | | | | | | | | | | | |
| | CMSX-4 and Specimen 3 had no intentional Y addition. | | | | | | | | | | | |

The comparison test specimens and the test alloys 1-2 each was made as a single crystal rod which was solution heat treated, hot isostatically pressed, and machined to provide a respective 1 inch diameter single crystal rod. The rod was EDM sliced into disk shaped coupons of 0.125 inch thickness which were ground, hand grit paper polished (600 grit paper) on the end faces, and media bowl polished.

Figure 1 illustrates that the nickel base superalloy test alloys 1 and 2 pursuant to the invention exhibited significantly lower weight loss at 2400 cycles than the CMSX-4 baseline test specimens and alloy 3 test specimens did at only 800 cycles. The nickel base superalloy test alloys 1 and 2 pursuant to the invention exhibited a mass loss per area per cycle of 0.002 and 0.010 mg/cm²-cycle, respectively. In contrast, the baseline CMSX-4 alloy had a mass loss rate of 0.167 mg/cm²-cycle. The addition to the alloy composition of the combination of Hf and Y in the amounts shown was effective to increase cyclic oxidation resistance of the specimens by well over a factor of 10. When a gas turbine engine blade is made of a superalloy pursuant to the invention, such improved alloy oxidation resistance will help retain turbine blade tip dimensions when a protective tip coating is removed by rubbing against the tip seal.

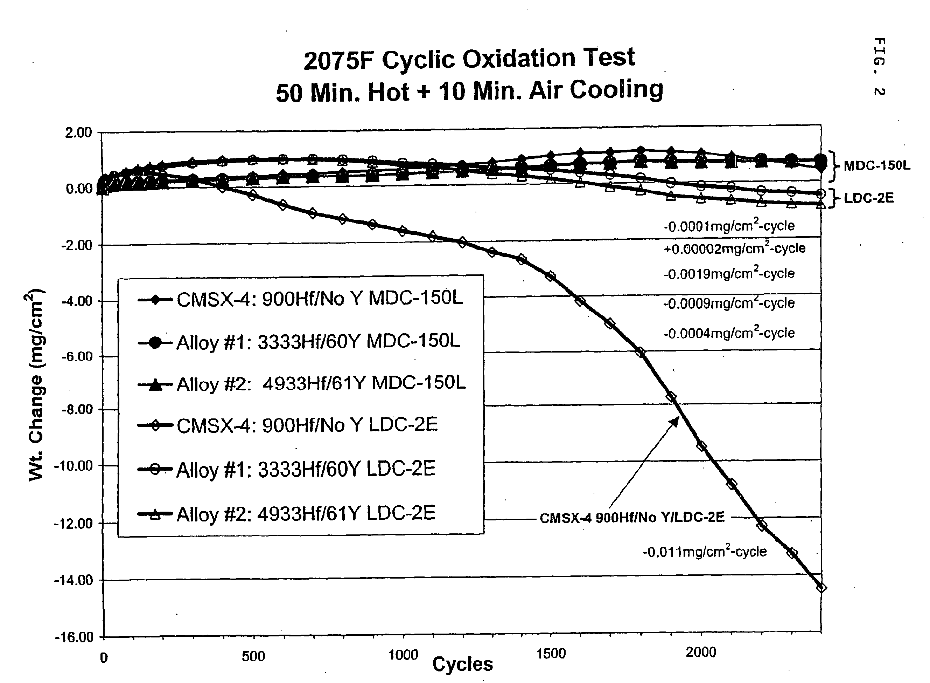

Figure 2 is a graph of weight change versus number of cycles for the cyclic oxidation test specimens listed in the figure having the outwardly grown, single phase aluminide diffusion MDC-150L bondcoat on some specimens and the inwardly grown, multi-phase aluminide diffusion LDC-2E bondcoat on other specimens. The MDC-150L bondcoat was formed on the CMSX-4 substrates as described in US Patents 5 261 963 and 5 264 245, the teachings of which are incorporated herein by reference. The LDC-2E bondcoat was formed on the CMSX-4 substrates as described in US Patent 3 677 789, the teachings of which are incorporated herein by reference.

For comparison, baseline specimens comprising CMSX-4 nickel base superalloy having the LDC-2E bondcoat thereon were tested. The CMSX-4 baseline test alloys of Figure 2 had a nominal composition as shown in Table 1. Also tested for comparison were CMSX-4 lime refined test specimens having the MDC-150L bondcoat thereon. Such lime refined CMSX-4 specimens were lime refined using the method of US Patent 5 922 148 such that the substrate CMSX-4 alloy had a sulfur content of less than 1 ppm by weight.

Figure 2 reveals that the LDC-2E bondcoated test specimens including the combination of Hf and Y in the substrate alloy pursuant to the invention exhibited significantly increased cyclic oxidation resistance as compared to that of the CMSX-4 baseline test specimens having the same bondcoat thereon. Figure 2 also reveals that the MDC-150L bondcoated specimens including the combination of Hf and Y in the substrate alloy pursuant to the invention exhibited cyclic oxidation resistance comparable to the already good cyclic oxidation resistance exhibited by the CMSX-4 baseline test specimens having the same bondcoat thereon. Closer inspection of the data curves and weight loss slopes reveals that the LDC-2E coated baseline CMSX-4 alloy has started to lose weight faster than the coated test alloys 1 and 2 having the Hf and Y additions. The coating life of the LDC-2E coated baseline CMSX-4 alloy will be shorter than that of the LDC-2E coated test alloys 1 and 2 if the test is continued.

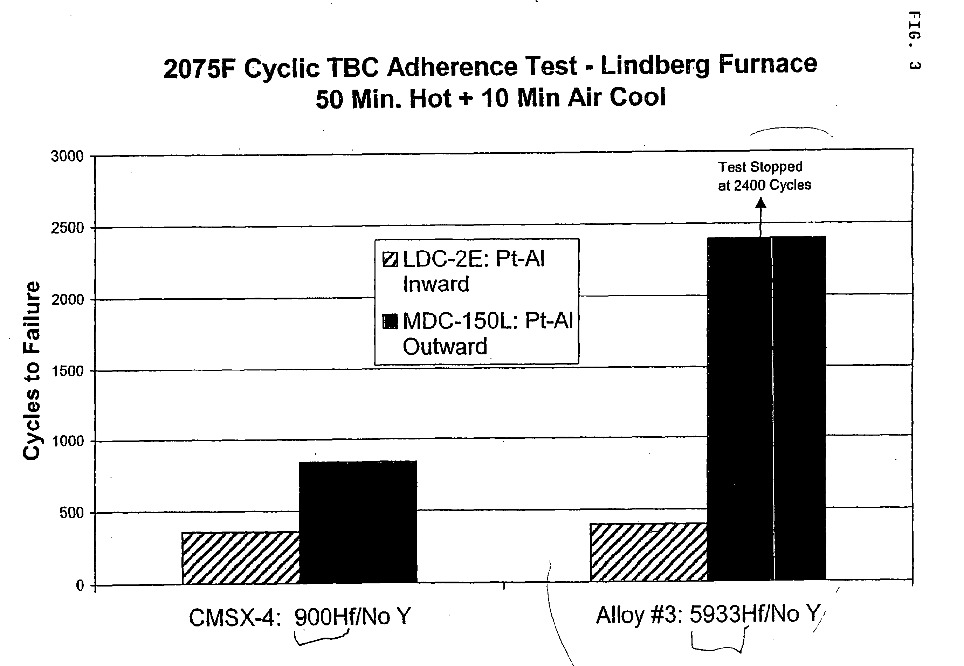

Figure 3 is a bar graph showing TBC adherence on substrates having the outwardly grown aluminide diffusion MDC-150L bondcoat on some CMSX-4 test specimens and the inwardly grown aluminide diffusion LDC-2E bondcoat on other CMSX-4 test specimens in the above described Lindberg test. A specimen was considered failed in the cyclic oxidation testing when the thermal barrier coating was 20% spalled off on a surface area basis.

Hafnium-modified CMSX-4 test specimens having the MDC-150L bondcoat applied as described above were coated with a thermal barrier coating (TBC) and tested for TBC adherence in cyclic oxidation test at 2075 degrees F using heating/cooling cycles as described above (Lindberg test) . Hafnium modified CMSX-4 specimens having the LDC-2E bondcoat applied as described above were coated with the same TBC and were similarly tested for TBC adherence. The thermal barrier coating applied to the specimens comprised 7 weight % yttria stabilized zirconia and was applied to the bondcoat of these specimens as described in US Patent 5 716 720, the teachings of which is incorporated herein by reference. The TBC thickness was in the range of 0.004 to 0.006 inch. The CMSX-4 substrates had a nominal composition shown for alloy 3 in Table 1 where Hf was present in an amount of 5933 ppm by weight.

Figure 3 reveals that the addition of 5933 ppm Hf to the test specimen substrate alloy (alloy 3) significantly improved TBC adherence for the specimens having the MDC-150L bondcoat thereon as compared to the CMSX-4 substrates (900 ppm Hf/no Y) having the same bondcoat and TBC thereon. The addition of 5933 ppm Hf to the test specimen substrate (alloy 3) having the LDC-2E bondcoat did not improve TBC adherence as compared to the CMSX-4 substrates (900 ppm Hf/no Y) having the same bondcoat and TBC thereon.

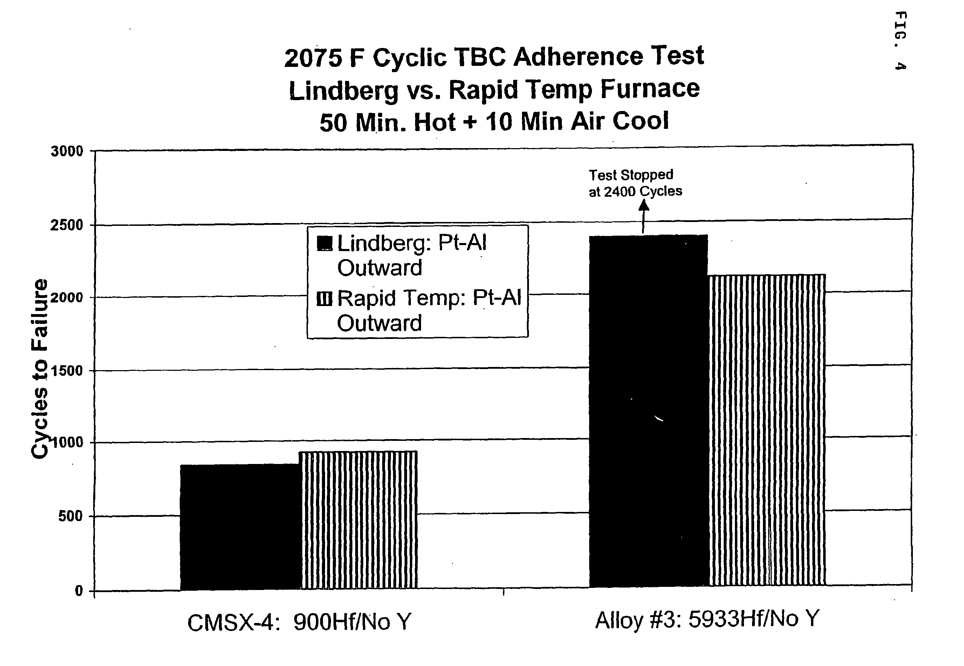

Figure 4 is a bar graph showing cyclic oxidation TBC adherence on substrates (alloy 3) having the outwardly grown diffusion aluminide MDC-150L bondcoat in the above described Lindberg test and in a rapid temperature furnace test that involves performing the same thermal cycle as the Lindberg furnace test, except that the furnace bottom drops from the hot zone with the test coupons (specimens) and a fan cools the test coupons during the cooling portion of the cycle. A specimen was considered failed in either cyclic oxidation test when the thermal barrier coating was 20% spalled off on a surface area basis.

Hafnium-modified CMSX-4 specimens (alloy 3) having the MDC-150L bondcoat applied as described above were coated with a thermal barrier coating (TBC) of the type used in Figure 3. The CMSX-4 substrates had a nominal composition as shown in Table 1 for alloy 3 where Hf was present in an amount of 5933 ppm by weight.

Figure 4 reveals that the addition of 5933 ppm Hf to the specimen substrate alloy significantly improved TBC adherence for the specimens having the MDC-150L bondcoat in both the Lindberg and rapid temperature furnace tests. These results demonstrate the effect of Hf in two different thermal cycle test apparatus.

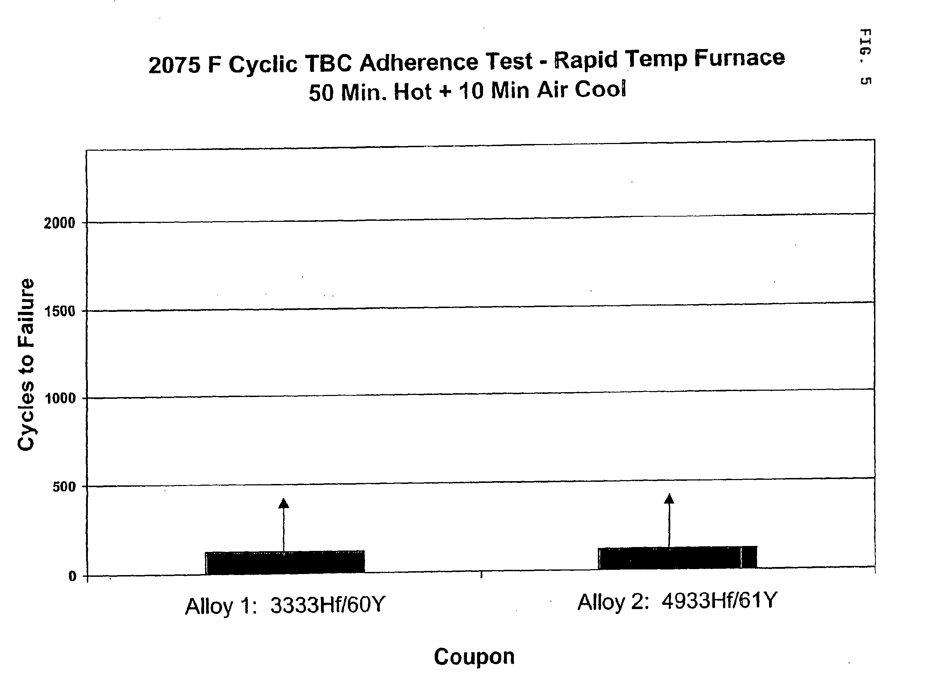

Figure 5 represents a rapid temperature furnace test in progress of alloys 1 and 2 having a MDC-150L bondcoat and a 7 weight % yttria stabilized zirconia TBC on the bondcoat to demonstrate the Hf effect, at lower Hf levels than Figure 4, with a 60-61 ppm Y addition to the alloy composition. At the number of cycles shown, neither coated test alloy had failed the test.

It is apparent that a nickel base superalloy pursuant to the invention possesses improved high temperature oxidation resistance by virtue of the inclusion of Hf and Y (or other rare earth element) pursuant to the invention. A nickel base superalloy substrate pursuant to the invention can be coated with an outwardly grown diffusion aluminide bondcoat (e.g. MDC-150L bondcoat) followed by deposition of a ceramic thermal barrier coating (TBC) on the bondcoat to provide a TBC coated substrate. Spallation of the TBC is significantly prolonged when the substrate comprises the superalloy pursuant to the invention and when the bondcoat comprises an outwardly grown diffusion aluminide bondcoat.

## Claims

1. A coated article, comprising a nickel base superalloy substrate consisting of, in weight %, 3 % to 12 % Cr, up to 15 % Co, up to 3 % Mo, 3 % to 10 % W, up to 6 % Re, 5% to 7% Al, up ton 2% Ti, up to 1% Fe, up to 2% Nb, 3% to 12% Ta, up to 0.07 % C, 0.030 % to 0,80 % Hf, up to 0.10 % Zr, up to 0.02 % B, 0.0005 % to 0.050 % of a rare earth element, and balance Ni and incidental impurities, an outwardly grown diffusion aluminide bondcoat on the substrate, and a ceramic thermal barrier coating disposed on the bondcoat, wherein the spallation of the thermal barrier coating due to cyclic oxidation is prolonged.

2. The article of claim 1 wherein the rare earth element is selected from the group consisting of Y and Lanthanide series elements with atomic numbers from 58 to 71.

3. The article of claim 1 or 2 having a sulfur concentration of 2 ppm by weight or less.

4. The article of one of claims 1 to 3 wherein the Hf concentration of the substrate is from 0.33 % to 0.80 % by weight.

## Patentansprüche

1. Beschichteter Artikel, umfassend ein Nickelbasis-Superlegierungssubstrat, bestehend - in Gewichtsprozent - aus 3 % bis 12 % Cr, bis zu 15 % Co, bis zu 3 % Mo, 3 % bis 10 % W, bis zu 6 % Re, 5 % bis 7 % Al, bis zu 2 % Ti, bis zu 1 % Fe, bis zu 2 % Nb, 3 % bis 12 % Ta, bis zu 0,07 % C, 0,030 % bis 0,80 % Hf, bis zu 0,10 % Zr, bis zu 0,02 % B, 0,0005 % bis 0,050 % eines Seltenerd-Elements, Rest Ni und begleitende Verunreinigungen, ein auswärts gewachsenes Diffusions-Aluminid-Bondcoat auf dem Substrat und eine auf dem Bondcoat angeordnete keramische Wärmebarrierebeschichtung, wobei die Spallation der Wärmebarrierebeschichtung infolge zyklischer Oxidation aufgeschoben ist.

2. Artikel nach Anspruch 1, wobei das Seltenerd-Element ausgewählt ist aus der Gruppe, welche aus Y und Elementen aus der Reihe der Lanthaniden mit Atomzahlen von 58 bis 71 besteht.

3. Artikel nach Anspruch 1 oder 2 mit einer Schwefelkonzentration von 2 Gew.-ppm oder weniger.

4. Artikel nach einem der Ansprüche 1 bis 3, wobei die Hf-Konzentration des Substrats im Bereich von 0,33 bis 0,80 Gew.% liegt.

## Revendications

1. Article revêtu, comprenant un substrat de superalliage à base de nickel composé, en % en poids, de 3% à 12% de Cr, jusqu'à 15% de Co, jusqu'à 3% de Mo, de 3% à 10% de W, jusqu'à 6% de Re, de 5% à 7% d'Al, jusqu'à 2% de Ti, jusqu'à 1% de Fe, jusqu'à 2% de Nb, de 3% à 12% de Ta, jusqu'à 0,07% de C, de 0,030% à 0,80% de Hf, jusqu'à 0,10% de Zr, jusqu'à 0,02% de B, de 0,0005% à 0,050% d'un élément des terres rares, et le complément de Ni et d'impuretés secondaires, une couche d'ancrage d'aluminure à diffusion croissant vers l'extérieur sur le substrat, et un revêtement céramique servant de barrière thermique disposé sur la couche d'ancrage, dans lequel la spallation du revêtement servant de barrière thermique due à une oxydation cyclique est prolongée.

2. Article selon la revendication 1, dans lequel l'élément des terres rares est choisi dans le groupe constitué par Y et les éléments de la série des lanthanides de numéro atomique 58 à 71.

3. Article selon la revendication 1 ou 2 ayant une concentration en soufre de 2 ppm en poids ou moins.

4. Article selon l'une quelconque des revendications 1 à 3, dans lequel la concentration en Hf du substrat est de 0,33% à 0,80% en poids.
